# EUROPEAN PATENT SPECIFICATION

(11) **EP 0 947 884 B1**
(45) Date of publication and mention of the grant of the patent: **10.03.2004**
(21) Application number: 99302392.8
(22) Date of filing: 29.03.1999
(51) Int. Cl.: G03F 7/20

(54) **Lithographic projection apparatus with substrate holder**
Lithographischer Projektionsapparat mit Substrathalter
Appareil de projection lithographique avec porte-substrat

(30) Priority: 31.03.1998 EP 98201004
(43) Date of publication of application: 06.10.1999
(73) Proprietor: ASML Netherlands B.V., 5503 LA Veldhoven (NL)
(72) Inventor: Van Empel, Tjarko Adriaan Rudolf, 5643 SC Eindhoven (NL)
(74) Representative: Leeming, John Gerard

(56) References cited:
- US-A- 4 213 698
- US-A- 5 324 012
- US-A- 5 583 736
- US-A- 5 923 408
- PATENT ABSTRACTS OF JAPAN vol. 12, no. 65 (E-586), 27 February 1988 (1988-02-27) & JP 62 208647 A (FUJITSU LTD.), 12 September 1987 (1987-09-12)
- PATENT ABSTRACTS OF JAPAN vol. 1998, no. 10, October 1998 (1998-10) & JP 10 128633 A (NIPPON TELEGR. & TELEOH. CORP.)

## Description

The invention relates to a lithographic projection apparatus comprising:
- a radiation system for supplying a projection beam of radiation;
- a mask table provided with a mask holder for holding a mask;
- a substrate table provided with a substrate holder for holding a substrate;
- a projection system for imaging an irradiated portion of the mask onto a target portion of the substrate,
the substrate holder comprising a plate having a face which is provided with a matrix arrangement of protrusions, each protrusion having an extremity remote from the face and being thus embodied that the said extremities all lie within a single substantially flat plane at a height *H* above the face, the substrate holder further comprising a wall which protrudes from the face, substantially encloses the matrix arrangement, and has a substantially uniform height *h* above the face, whereby *h < H*, the face inside the wall being provided with at least one aperture extending through the plate and through which the area enclosed by the wall can be accessed.

An apparatus of this type can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies which are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus - which is commonly referred to as a step-and-scan apparatus - each die is irradiated by progressively scanning the reticle pattern under the projection beam in a given reference direction (the "scanning" direction) while synchronously scanning the wafer table parallel or anti-parallel to this direction; since the projection system will have a magnification factor M (generally < 1), the speed v at which the wafer table is scanned will be a factor M times that at which the reticle table is scanned. More information with regard to lithographic devices as here described can be gleaned from International Patent Application WO 97/33205.

Up to very recently, apparatus of this type contained a single mask table and a single substrate table. However, machines are now becoming available in which there are at least two independently movable substrate tables; see, for example, the multi-stage apparatus described in International Patent Applications WO 98/28665 (P-0071) and WO 98/40791 (P-0101). The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial alignment measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

In order to achieve good image definition and layer overlay in each die, the irradiated surface of the wafer should be kept as flat and as stationary as possible during exposure of the wafer. Known lithographic apparatus addresses these demands using the substrate holder hereabove specified, on which a wafer can be placed so that its backside is in contact with the protrusions, all of which lie in a well-defined plane. By connecting the aperture(s) in the plate to vacuum generating means, the backside of the wafer can be sucked securely against the protrusions, whereby the wall serves to contain the partial vacuum thereby required; to this end, the wall geometry must be matched to a given wafer diameter, so that the wafer overshoots the wall (typically by a margin of the order of about 2 mm). The use of protrusions in this manner ensures that only a fraction of the area of the backside is actually pressed against a solid surface; in this way, the distorting effect of any particulate contamination on the backside of the wafer is minimized, since such contamination will most probably be situated in the empty spaces between protrusions rather than being pressed against the top surface of a protrusion.

A problem with this known approach is that, since the wafer rests on a discrete number of protrusions rather than a continuous flat surface, and since the backside of the surface is sucked forcefully against such protrusions, the (elastic) wafer can tend to "sag" in areas where it is not supported by a protrusion. This effect can be a particular nuisance along the edge of the wafer, where the resulting distortion of wafer flatness can result in poor-quality edge dies.

US 5,324,012 discloses a substrate holder with a rectangular grid of protrusions, as does US 5,583,736.

It is an object of the invention to alleviate this problem. More specifically, it is an object of the invention to provide a lithographic projection apparatus having a substrate holder which ensures excellent substrate flatness over the whole surface of a substrate held thereupon. In particular, it is an object of the invention that, when a semiconductor wafer is held on such a substrate holder, the flatness of the wafer's edges should fall within the specifications required to produce satisfactory edge dies, at least for resolutions down to 0.20 µm.

According to the present invention, there is provided a substrate holder as defined in the appended claims. The invention also provides a lithographic apparatus and a device manufacturing method using the substrate holder.

In experiments leading to the invention, the inventor arrived at the insight that the deviation from flatness along the edge of a wafer on the known substrate holder was dependent on a number of factors, including the form of the matrix distribution of protrusions, the form of the wall, and the interface between the wall and the protrusions. After performing numerical modeling and subsequent tests, it was found that edge flatness was improved if a uniform separation x was maintained between the wall and the outlying protrusions of the enclosed matrix distribution. However, this measure in itself was not enough to ensure acceptable edge flatness, and any attempts to tune the value of *x* led to confusing results, whereby unacceptable edge flatness was observed both for relatively small and relatively large values of *x*. Upon further analysis, it transpired surprisingly that the value of *x* had an effect not only on the magnitude of the distortion (deflection) along the edge of the wafer, but also on its sign, *i*.*e*. the wafer could deflect up or down relative to the face. Taking this into account, subsequent refinements by the inventor produced a range of values of *x* for which the sign of the distortion was substantially zero, or at least only weakly positive or negative. Surprisingly, it was found that this range of values was substantially independent of the height *h* of the wall relative to the height *H* of the protrusions. Summarizing, the following conditions were derived:
- In order to ensure a uniform value of *x*, the wall should be equidistant from the outlying protrusions. To ensure optimum support of circular wafers, the wall and the outlying portion of the matrix distribution therefore should have concentric circular geometries;
- In principle, the inner portion of the matrix distribution (*i*.*e*. that part of the distribution excluding the outermost two circles of protrusions) does not have to have circular geometry, *e.g.* it might be given an orthogonal or honeycomb geometry. However, a problem with non-circular geometry in the inner portion is that it is then difficult to achieve a smooth geometrical transition between the inner and outlying portions of the distribution (whereby a geometrical mismatch would lead to poor wafer support in the vicinity of the transition zone). For this reason, it is best to endow the whole matrix distribution (both inner and outlying portions) with a circular geometry;
- If the radial separation of the outlying circles in the matrix arrangement has a value *d*, then the value of *x* should be chosen so that 0.3 < *x*/*d* < 0.6.
Tests performed with a substrate holder satisfying these specifications yielded excellent results, as will be further elucidated in the exemplary embodiments below.

The term "substantially circular" as used with regard to the wall should be interpreted as implying that at least 80% of the circumference of the wall follows a circular path. The remaining 20% of the wall may, of course, also follow the same circular path; alternatively, it may, for example, comprise a notch (so as to be compatible with notched wafers) or a straight portion (so as to be compatible with wafers having a flat edge). Similarly, the "concentric circles" in the matrix arrangement may deviate from exact circularity in the vicinity of such a notch or flat edge, but at least 80% of their circumference will be truly circular. In both cases, the term "arcurate interval" is to be construed as referring to a perimetric distance (arc length) measured along the circumference of the wall or one of the concentric circles.

It should be noted that, where reference is made in this text to a distance between two objects (such as *x*, *d* or *y*, for example), such distance should be regarded as being measured between heart lines (centerlines) passing through the two objects concerned. For example, the distance d between two cylindrical protrusions is the distance between their cylindrical axes, measured parallel to the face from which the protrusions extend outward.

A preferential embodiment of the apparatus according to the invention is characterized in that *x* satisfies the relationship 0.43 < *x*/*d* < 0.47. This range of values has been found to give a deflection of substantially zero magnitude along the edge of the wafer.

In a particular embodiment of the apparatus according to the invention, the quadrilateral (parallelepiped) area defined by a pair of adjacent protrusions in one circle and the corresponding nearest pair of adjacent protrusions in an adjacent circle has a substantially constant size, independent of the location of the quadrilateral in the matrix distribution. The term "substantially" as here employed should be interpreted as requiring the area of any first quadrilateral area to be equal to the area of any second quadrilateral area to within ±10%. Such an arrangement achieves a substantially homogeneous distribution of protrusions over the area of the wafer.

Another embodiment of the apparatus according to the invention is characterized in that the mutual radial separation of any pair of adjacent circles is substantially equal to *d*. The term "substantially equal" should here be interpreted as referring to a value which is equal to *d* within ±10%. Such an embodiment further optimizes the uniformity with which the backside of the wafer is supported.

In a specific embodiment of the apparatus specified in the previous paragraph, the face further comprises a plurality of hollow shafts disposed around the common center of the circles and through each of which a piston can be moved so as to protrude through the said substantially flat plane, such an embodiment being characterized according to the invention in that each shaft is separately enclosed by a retaining wall (vacuum wall) which protrudes from the face and which has the form of a polygon, and that the shortest distance y from any side of the polygon to an adjacent protrusion outside the polygon satisfies the relationship 0.25 < *y*/*d* < 0.45. The purpose of the said pistons is to raise and lower the wafer off and onto the protrusions, so that the wafer can be transferred to or received from a handling robot arm. The particular range of values here stipulated for the ratio *y*/*d* was determined by the inventor on the basis of calculations and experiments, and is optimized to account for that fact that, since a vacuum may be present on the outside of the polygon but not on its inside, there is a substantial variation (as a function of in-plane position) in the perpendicular force exerted on the wafer in the vicinity of the polygon. Choosing *y* so as to satisfy the indicated relationship serves to minimize the distorting effects of such differential forces.

The term "shortest distance" as employed in the previous paragraph refers to the length of a line segment joining the relevant protrusion to the relevant side of the polygon, or to a linear extension of that side, and extending perpendicular to the said side.

A particular embodiment of an apparatus as specified in the previous paragraph is characterized in that the polygon is a hexagon and that *y* satisfies the relationship 0.33 *< y*/*d* < 0.37. This particular choice of geometry and spacing gives particularly satisfactory results with regard to wafer flatness.

In a further embodiment of the apparatus according to the invention, the value of *H* lies in the range 75 µm - 125 µm. On the one hand, it is desirable to have the protrusions as low as possible, so as to optimize heat transfer between the substrate and the holder; this is particularly important in the case of a wafer, which should reach thermal equilibrium with the holder as quickly as possible so as to avoid contraction or expansion (with attendant overlay errors) during exposure. However, on the other hand, if *H* is too small, this can result in too great a pressure drop between the wall and the vacuum aperture(s); this in turn slows vacuum generation and vacuum removal (thus reducing throughput) as well as resulting in a non-homogeneous vacuum (thus reducing wafer flatness isometry). A good working compromise between these conflicting effects is achieved by choosing *H* to lie in the said range.

Another embodiment of the apparatus according to the invention is characterized in that 1 µm < *H-h* < 5 µm. If *H-h* is too large, the result will be an unacceptable vacuum leak over the wall. On the other hand, *H-h* should be larger than the average (RMS) roughness of the backside of the wafer. Again, a good working compromise between these demands is achieved by choosing *H-h* to lie in the stipulated range.

It should be particularly noted that the invention lends itself for use in "single-stage" or "multi-stage" lithographic apparatus, is suited to various wafer sizes (e.g. 150-mm, 200-mm, 300-mm or 450-mm wafers), and can be employed both in current lithographic systems (using UV light) and next-generation lithographic devices (*e*.*g*. using EUV, electrons or ions, in a vacuum environment).

Although specific reference has been made hereabove to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc.* The skilled artisan will appreciate that, in the context of such alternative applications, any use of the terms "reticle", "wafer" or "die" in this text should be considered as being replaced by the more general terms "mask", "substrate" and "target area", respectively.

The invention and its attendant advantages will be further elucidated with the aid of exemplary Embodiments and the accompanying schematic drawings, wherein:
Figure 1 renders a plan view of part of a substrate holder in accordance with the invention;
Figure 2 renders a cross-sectional view of part of the subject of Figure 1, taken along a diameter;
Figure 3 shows a perspective view of a lithographic projection apparatus according to the invention, containing a substrate holder as depicted in Figures 1 and 2;
Figure 4 graphically depicts the vertical deformation Δ of a wafer as a function of wafer radius *r* in a substrate holder according to the invention, for various values of the radial distance *x* from the wall to the outermost circle of protrusions in that holder.

Corresponding features in the various Figures are denoted by the same reference symbols.

### Embodiment 1

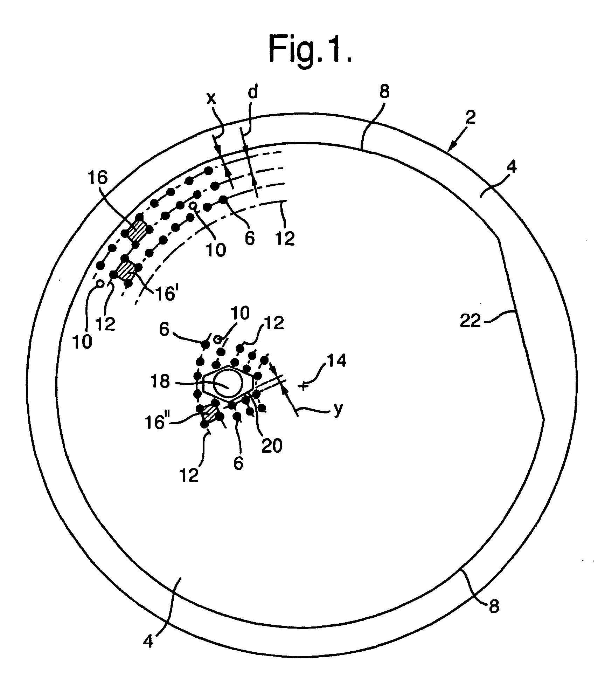

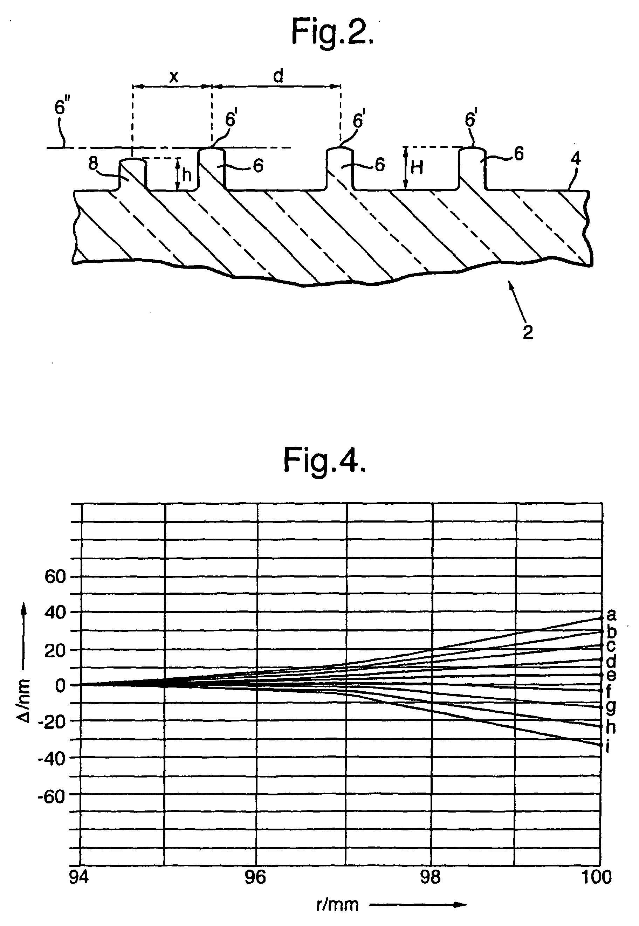

Figures 1 and 2 show various aspects of a substrate holder in accordance with the invention. The plan view in Figure 1 is rendered in partial diametric cross-section in Figure 2.

The depicted substrate holder comprises a plate 2 having a face 4 which is provided with a matrix arrangement of protrusions 6 (*e.g.* cylindrical burls emerging out of the face 4). Each protrusion 6 has an extremity 6' remote from the face 4 and is thus embodied (dimensioned) that the said extremities 6' all lie within a single substantially flat plane 6" at a height *H* above the face 4. The plate 2 further comprises a wall 8 which protrudes from the face 4, substantially encloses the matrix arrangement, and has a substantially uniform height *h* above the face 4, whereby *h < H*. The face 4 inside the wall 8 is provided with a distributed plurality of apertures 10 extending through the plate 2; through these apertures 10, the area enclosed by the wall 8 is connected to a vacuum pump. For the sake of clarity, only a small subset of the various protrusions 6, apertures 10 and circles 12 are shown in the Figures; in reality, the protrusions 6 are distributed over substantially the whole area enclosed by the wall 8.

As here depicted, the matrix arrangement comprises a series of concentric circles 12 along which the protrusions 6 are disposed at substantially regular arcurate intervals. The wall 8 is also circular, except in that it contains a relatively short straight portion 22. The wall 8 and circles 12 are concentric about a common center 14. The radial separation of the two outermost circles 12 is *d*, and, in this particular embodiment, the radial separation of any other pair of adjacent (consecutive) circles 12 is also *d*. On the other hand, the radial distance between the wall 8 and the circle 12 nearest thereto is *x*. The value of *x* is engineered such that the ratio *x*/*d* lies in the range 0.3-0.6, and, more specifically, has a value of approximately 0.45.

Also depicted as shaded features in the Figure are three different quadrilateral (parallelepiped) areas 16,16',16", each of which is defined by an adjacent pair of protrusions 6 in one circle 12 and the nearest adjacent pair of protrusions 6 in an adjacent (consecutive) circle 12. In this embodiment, the arcurate spacings of adjacent protrusions 6 in the various circles 12 are chosen such that all such quadrilateral areas 16 are of substantially the same size (same area).

Figure 1 also shows one of a series of hollow shafts 18 which are symmetrically disposed around the common center 14 of the circles 12. Through each shaft 18 a piston can be moved so as to protrude through the flat plane 6" defined by the outward-facing extremities 6' of the protrusions 6. Each shaft 18 is separately enclosed by a retaining wall 20 which protrudes outward from the face 4 and which has the form of a polygon. The retaining wall 18 is thus configured that the shortest distance *y* from any side of the polygon 20 to an adjacent protrusion 6 outside the polygon 20 satisfies the relationship 0.25 < *y*/*d* < 0.45, with a specific value *y*/*d* = 0.32.

In this particular example, the plate 2 is comprised of vitreous material, *e*.*g*. ceramic or glass. The height *H* of the protrusions 6 is approximately 100 µm, whereas the height *h* of the wall 8 (and also of the retaining wall 20) is approximately 97 µm. The value of *d* is, for example, of the order of 1 mm. Such protrusions 6 and walls 8,20 can be manufactured by a mechanical or chemical subtractive process. For example, a bare vitreous plate can be provided on one face with a mask corresponding to the desired positions of the protrusions 6 and walls 8,20, and the unmasked portions of the plate can then be exposed to an etchant for a pre-determined time.

### Embodiment 2

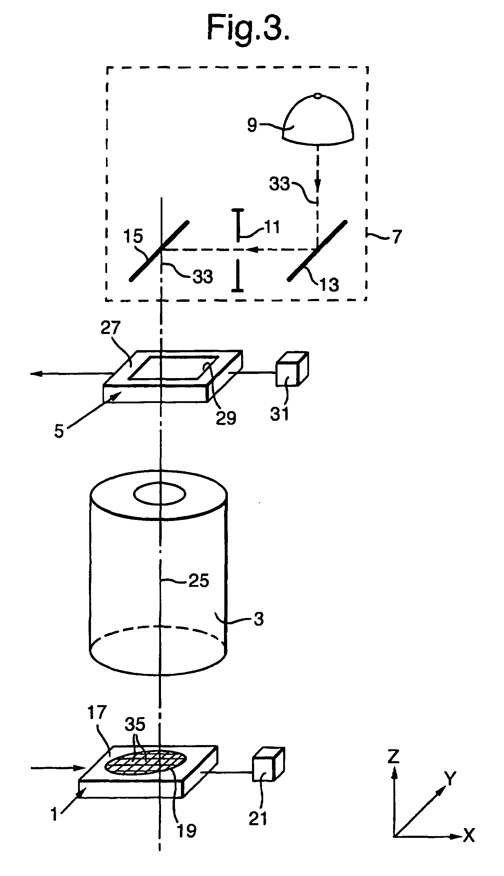

Figure 3 renders a schematic perspective view of a lithographic projection apparatus according to the invention. The apparatus comprises:
- a radiation system 7 for supplying a projection beam 25 of radiation (*e.g.* ultraviolet (UV) light, Extreme UV (λ ∼ 5-20 nm), or a beam of electrons or ions);
- a mask table 5 provided with a mask holder 27 for holding a mask 29 (*e.g.* a reticle);
- a substrate table 1 provided with a substrate holder 17 for holding a substrate 19 (*e.g.* a resist-coated silicon wafer). According to the invention, the substrate holder 17 comprises a plate 2 as further elucidated in Embodiment 1 above;
- a projection system 3 (*e*.*g*. a lens, mirror group or catadioptric system, or a particle focusing system) for imaging an irradiated portion of the mask 29 onto a target portion 35 (die) of the substrate 19.

The radiation system 7 comprises a source 9 (*e.g.* a Hg lamp or excimer laser) which produces a beam 33 of radiation. This beam 33 is passed along various optical components (such as a stop 11 and selective mirrors 13,15, and/or components such as a condensor lens, intensity integrator, *etc*.) so that the beam 25 emerging from the system 7 is substantially collimated, monochromatic and uniformly intense throughout its cross-section.

The beam 25 subsequently intercepts a reticle 29 which is held in a mask holder 27 on a mask table 5. With the aid of the displacement means 31, the mask table 5 can be moved accurately back and forth at least along the X-direction (the so-called scan direction).

Having passed through (or been reflected from) the reticle 29, the beam 25 passes through a projection system 3, which focuses the beam 25 onto a die 35 of the wafer 19. With the aid of the displacement means 21, the substrate table 1 can also be moved accurately back and forth along the X-direction (scan direction). However, the substrate table 1 can also be moved back and forth in the Y-direction.

The depicted apparatus can be used in two different modes:
- In step mode, the reticle table 5 is kept stationary, and an entire reticle image is projected in one go (*i*.*e*. a single "flash") onto a wafer die 35. The substrate table 1 is then shifted in the X and/or Y directions so that a different die 35 can be irradiated by the (stationary) beam 25;
- In scan mode, essentially the same scenario applies, except in that a given die 35 is not exposed in a single "flash". Instead, the reticle table is moved in the scan direction with a speed *v*, so that the projection beam 25 is caused to scan over a reticle image, and the substrate table 1 is simultaneously moved in the same or opposite direction at a speed *V* = *Mv*, in which *M* is the magnification of the projection system 3 (typically, *M =* 1/4 or 1/5). In this manner, a relatively large die can be exposed, without having to compromise on resolution.

### Embodiment 3

Figure 4 graphically depicts the vertical deformation Δ (in nm) of a 200-mm wafer 19 as a function of wafer radius *r* (in mm) in a plate 2 as described in Embodiment 1, for various values of the radial distance *x* from the wall 8 to the outermost circle 12 of protrusions 6. The radius *r* is measured from the common center 14. In this particular embodiment, the wall 8 is located at *r* = 97.75 mm, and the value of *d* is 2.54 mm. The curves a-i in Figure 4 correspond to various values of *x*, starting at *x* = 1 mm (curve a) and increasing in steps of 0.05 mm to *x* = 1.4 mm (curve i). In accordance with the invention, all of these values of *x* satisfy the relationship 0.39 < *x*/*d* < 0.55.

The maximum value of Δ is 37 nm (curve a), whereas the minimum value of Δ is about 4 nm (curve f). All values of Δ in the Figure fall well within a tolerance of 100 nm (and most within a tolerance of 50 nm).

## Claims

1. A substrate holder for use in a lithographic projection apparatus, the substrate holder (17') comprising a plate (2) having a face (4) which is provided with a matrix arrangement of protrusions (6), each protrusion having an extremity (6') remote from the face and being thus embodied that the said extremities all lie within a single substantially flat plane (6") at a height *H* above the face, the substrate holder further comprising a wall (8) which protrudes from the face, substantially encloses the matrix arrangement, and has a substantially uniform height *h* above the face, whereby *h* < *H*, the face inside the wall being provided with at least one aperture (10) extending through the plate and through which the area enclosed by the wall can be accessed,
**characterized in that**:
- the matrix arrangement comprises a series of concentric circles (12) whereby the protrusions are disposed along each circle at substantially regular arcurate intervals;
- the wall is substantially circular, and is concentric with the said circles;
- the radial distance x between the wall and the circle nearest thereto satisfies the relationship 0.3 < *x*/*d* < 0.6, where *d* is the mutual radial separation of the two circles nearest the wall.

2. A substrate holder according to Claim 1, **characterized in that** *x* satisfies the relationship 0.43 < *x*/*d* < 0.47.

3. A substrate holder according to Claims 1 or 2, **characterized in that** the quadrilateral area (16) defined by a pair of adjacent protrusions in one circle and the corresponding nearest pair of adjacent protrusions in an adjacent circle has a substantially constant size, independent of the location of the quadrilateral in the matrix distribution.

4. A substrate holder according to any one of the preceding Claims, **characterized in that** the mutual radial separation of any pair of adjacent circles is substantially equal to *d*.

5. A substrate holder according to Claim 4, in which the face further comprises a plurality of hollow shafts (18) disposed around the common center (14) of the circles and through each of which a piston can be moved so as to protrude through the said substantially flat plane, **characterized in that** each shaft is separately enclosed by a retaining wall which protrudes from the face and which has the form of a polygon, and that the shortest distance *y* from any side of the polygon to an adjacent protrusion outside the polygon satisfies the relationship 0.25 < *y*/*d* < 0.45.

6. A substrate holder according to Claim 5, **characterized in that** the polygon is a hexagon and that *y* satisfies the relationship 0.33 < *y*/*d* < 0.37.

7. A substrate holder according to any one of the Claims 1-6, **characterized in that** *H* satisfies the relationship 75 µm < *H* < 125 µm.

8. A substrate holder according to Claim 7, **characterized in that** *h* satisfies the relationship 1 µm < *H-h* < 5 µm.

9. A lithographic projection apparatus comprising:
a radiation system (7) for supplying a projection beam (25) of radiation;
a mask table (5) provided with a mask holder (27) for holding a mask (29);
a substrate table (1) provided with a substrate holder (17) for holding a substrate (19); and
a projection system (3) for imaging an irradiated portion of the mask (29) onto a target portion of the substrate (19),
wherein the substrate holder (17) is according to any one of the preceding claims.

10. A device manufacturing method comprising the steps of:
- providing a substrate which is at least partially covered by a layer of radiation-sensitive material;
- providing a mask which contains a pattern;
- using a projection beam of radiation to project an image of at least part of the mask pattern onto a target area of the layer of radiation-sensitive material,
whereby, at least during the projection step, the substrate is held on a substrate holder according to any one of claims 1 to 8.

## Patentansprüche

1. Substrathalter zur Verwendung in einem lithografischen Projektionsapparat, wobei der Substrathalter (17') eine Platte (2) mit einer Fläche (4) aufweist, die mit einer Matrixanordnung von Vorsprüngen (6) versehen ist, wobei jeder Vorsprung ein von der Fläche entferntes äußerstes Ende (6') hat und daher so ausgeführt ist, dass die genannten äußersten Enden alle innerhalb einer einzigen im Wesentlichen flachen Ebene (6") in einer Höhe *H* über der Fläche liegen, wobei der Substrathalter zudem eine Wand (8) umfasst, die aus der Fläche ragt, im Wesentlichen die Matrixanordnung einschließt und eine im Wesentlichen einheitliche Höhe *h* über der Fläche hat, wobei *h* < *H* ist und die Fläche innerhalb der Wand mit wenigstens einer Lochblende (10) ausgestattet ist, die sich durch die Platte erstreckt und durch welche auf die von der Wand eingeschlossene Fläche zugegriffen werden kann,
**dadurch gekennzeichnet, dass**:
- die Matrixanordnung eine Reihe von konzentrischen Kreisen (12) aufweist, wobei die Vorsprünge entlang jedes Kreises in im Wesentlichen regulären genauen Abständen angeordnet sind;
- die Wand im Wesentlichen kreisförmig und konzentrisch mit den genannten Kreisen ist;
- die radiale Entfernung *x* zwischen der Wand und dem dazu nächstgelegenen Kreis die Beziehung 0,3 < *x*/*d* < 0,6 erfüllt, wobei *d* der gegenseitige radiale Abstand zweier der Wand nächstgelegenen Kreise ist.

2. Substrathalter gemäß Anspruch 1, **dadurch gekennzeichnet, dass** *x* die Beziehung 0,43 < *x*/*d* < 0,47 erfüllt.

3. Substrathalter gemäß Ansprüchen 1 oder 2, **dadurch gekennzeichnet, dass** die von einem Paar von benachbarten Vorsprüngen in einem Kreis und dem entsprechenden nächstgelegenen Paar von benachbarten Vorsprüngen in einem benachbarten Kreis definierte vierseitige Fläche (16) eine im Wesentlichen konstante Größe hat, unabhängig von der Lage der vierseitigen Fläche in der Matrixverteilung.

4. Substrathalter gemäß einem der vorhergehenden Ansprüche, **dadurch gekennzeichnet, dass** der gegenseitige radiale Abstand jedes Paars von benachbarten Kreisen im Wesentlichen gleich *d* ist.

5. Substrathalter gemäß Anspruch 4, in welchem die Fläche zudem eine Vielzahl von Hohlschäften (18) aufweist, welche rund um das gemeinsame Zentrum (14) der Kreise angeordnet sind und durch welche ein Kolben bewegt werden kann, um durch die genannte im Wesentlichen flache Ebene zu ragen, **dadurch gekennzeichnet, dass** jeder Schaft separat von einer Haltewand eingeschlossen ist, die aus der Fläche ragt und die Form eines Vielecks hat, und dass die kürzeste Distanz *y* von jeder Seite des Vielecks zu einem benachbarten Vorsprung außerhalb des Vielecks die Beziehung 0,25 < *y*/*d <* 0,45 erfüllt.

6. Substrathalter gemäß Anspruch 5, **dadurch gekennzeichnet, dass** das Vieleck ein Sechseck ist und dass *y* die Beziehung 0,33 < *y*/*d <* 0,37 erfüllt.

7. Substrathalter gemäß einem der Ansprüche 1 bis 6, **dadurch gekennzeichnet, dass** *H* die Beziehung 75 µm < *H* < 125 µm erfüllt.

8. Substrathalter gemäß Anspruch 7, **dadurch gekennzeichnet, dass** *h* die Beziehung 1 µm < *H-h <* 5 µm erfüllt.

9. Lithografischer Projektionsapparat, folgendes aufweisend:
ein Strahlungssystem (7) zum Bereitstellen eines Projektionsstrahls (25);
einen Maskentisch (5), der mit einem Maskenhalter (27) zum Halten einer Maske (29) ausgestattet ist;
einen mit einem Substrathalter (17) ausgestatteten Substrattisch (1) zum Halten eines Substrats (19); und
ein Projektionssystem (3) zum Abbilden eines bestrahlten Teils der Maske (29) auf einen Zielbereich des Substrats (19),
worin der Substrathalter (17) einem der vorhergehenden Ansprüche entspricht.

10. Vorrichtungsherstellungsverfahren, folgende Schritte umfassend:
- Bereitstellen eines Substrats, das zumindest teilweise von einer Schicht aus strahlungsempfindlichen Material bedeckt ist;
- Bereitstellen einer Maske, die ein Muster enthält;
- Verwenden eines Projektionsstrahls, um ein Bild von wenigstens einem Teil des Maskenmusters auf einen Zielbereich der Schicht aus strahlungsempfindlichen Material zu projizieren, wobei, zumindest während des Projektionsschritts, das Substrat auf einem Substrathalter gemäß einem der Ansprüche 1 bis 8 gehalten wird.

## Revendications

1. Porte-substrat à utiliser dans un dispositif de projection lithographique, le porte-substrat (17') comportant une plaque (2) ayant une face (4) qui présente un agencement de saillies en matrice (6), chaque saillie ayant une extrémité (6') distante de la face et étant réalisée de telle sorte que lesdites extrémités se situent toutes dans un plan unique sensiblement plat (6") à une hauteur *H* au-dessus de la face, le porte-substrat comportant en outre une paroi (8) qui fait saillie à partir de la face, entoure sensiblement l'agencement en matrice, et a une hauteur sensiblement uniforme *h* au-dessus de la face, avec *h* < *H*, la face située à l'intérieur de la paroi étant munie d'au moins une ouverture (10) qui s'étend à travers la plaque et à travers laquelle on peut accéder à la zone entourée par la paroi, **caractérisé en ce que** :
- l'agencement en matrice comporte une série de cercles concentriques (12) de telle sorte que les saillies sont disposées le long de chaque cercle à des intervalles en forme d'arc sensiblement réguliers;
- la paroi est sensiblement circulaire, et est concentrique auxdits cercles;
- la distance radiale *x* entre la paroi et le cercle le plus proche de celle-ci satisfait à la relation 0,3 < *x*/*d* < 0,6, où *d* est la séparation radiale mutuelle des deux cercles les plus proches de la paroi.

2. Porte-substrat selon la revendication 1, **caractérisé en ce que** *x* satisfait à la relation 0,43 < *x*/*d* < 0,47.

3. Porte-substrat selon la revendication 1 ou 2, **caractérisé en ce que** la zone quadrilatérale (16) définie par une paire de saillies adjacentes d'un cercle et la paire de saillies adjacentes la plus proche correspondante d'un cercle adjacent a une taille sensiblement constante, indépendante de l'emplacement du quadrilatère dans la répartition en matrice.

4. Porte-substrat selon l'une quelconque des revendications précédentes, **caractérisé en ce que** la séparation radiale mutuelle d'une paire quelconque de cercles adjacents est sensiblement égale à *d*.

5. Porte-substrat selon la revendication 4, dans lequel la face comporte en outre une pluralité d'arbres creux (18) disposés autour du centre commun (14) des cercles et à travers chacun desquels un piston peut être déplacé de manière à faire saillie à travers ledit plan sensiblement plat, **caractérisé en ce que** chaque arbre est séparément entouré d'une paroi de retenue qui fait saillie à partir de la face et qui a la forme d'un polygone, et que la distance *y* la plus courte d'un côté quelconque du polygone à une saillie adjacente située à l'extérieur du polygone satisfait à la relation 0,25 < *y*/*d* < 0,45.

6. Porte-substrat selon la revendication 5, **caractérisé en ce que** le polygone est un hexagone et que *y* satisfait à la relation 0,33 < *y*/*d* < 0,37.

7. Porte-substrat selon l'une quelconque des revendications 1 à 6, **caractérisé en ce que** *H* satisfait à la relation 75 µm < *H* < 125 µm.

8. Porte-substrat selon la revendication 7, **caractérisé en ce que** *h* satisfait à la relation 1 µm < *H-h* < 5 µm.

9. Dispositif de projection lithographique comportant :
un système de rayonnement (7) pour délivrer un faisceau de projection (25) de rayonnement;
une table de masque (5) munie d'un porte-masque (27) pour porter un masque (29);
une table de substrat (1) munie d'un porte-substrat (17) pour porter un substrat (19); et
un système de projection (3) pour former une image d'une partie irradiée du masque (29) sur une partie cible du substrat (19),
dans lequel le porte-substrat (17) est selon l'une quelconque des revendications précédentes.

10. Procédé de fabrication de dispositif comportant les étapes consistant à :
- fournir un substrat qui est au moins partiellement recouvert d'une couche de matériau sensible à un rayonnement;
- fournir un masque qui contient un motif;
- utiliser un faisceau de projection de rayonnement pour projeter une image d'au moins une partie du motif de masque sur une zone cible de la couche de matériau sensible à un rayonnement,
dans lequel, au moins pendant l'étape de projection, le substrat est maintenu sur un porte-substrat selon l'une quelconque des revendications 1 à 8.
